(19) Europäisches Patentamt
European Patent Office
Office européen des brevets

(11) **EP 4 749 242 A1**

(12) **EUROPEAN PATENT APPLICATION**

(43) Date of publication:
**27.05.2026   Bulletin 2026/22**

(21) Application number: **25215826.6**

(22) Date of filing: **14.11.2025**

(51) International Patent Classification (IPC):
**G01B 11/06** $^{(2006.01)}$      **G01B 11/25** $^{(2006.01)}$
**G03F 9/00** $^{(2006.01)}$

(52) Cooperative Patent Classification (CPC):
**G01B 11/0608; G01B 11/25; G03F 9/7026;
G03F 9/7034;** G01B 2210/56

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority:  **22.11.2024   JP 2024204137**

(71) Applicant: **Canon Kabushiki Kaisha
Tokyo, 146-8501 (JP)**

(72) Inventor: **MOTOJIMA, Junichi
Ohta-ku, Tokyo, 146-8501 (JP)**

(74) Representative: **TBK
Bavariaring 4-6
80336 München (DE)**

(54)   **MEASUREMENT APPARATUS, MEASUREMENT METHOD, EXPOSURE METHOD,
EXPOSURE APPARATUS AND ARTICLE MANUFACTURING METHOD**

(57)    A measurement method of measuring a height position of a measurement region by irradiating the measurement region with light and detecting reflected light from the measurement region with a sensor, the method including obtaining information concerning a distribution of reflectances in the measurement region, and setting a measurement target location in a region where the amount of reflected light detected by the sensor falls within a predetermined range in the measurement region based on the information.

# F I G. 7

## Description

TECHNICAL FIELD

The present disclosure relates to a measurement apparatus, a measurement method, an exposure method, an exposure apparatus and an article manufacturing method.

BACKGROUND

Conventionally, as a measurement apparatus that measures the surface position (height position) of a measurement target, Japanese Patent Laid-Open No. 10-64980 has proposed a measurement apparatus that measures a surface position by projecting light from a light-emitting unit onto the measurement target and detecting light (reflected light) reflected by the measurement target using a light-receiving element. Japanese Patent Laid-Open No. 10-64980 discloses a technique of adjusting the amount of light projected from a light-emitting unit for each measurement location so as to enable accurate measurement of a surface position even if reflectance variation occurs due to the material, pattern, or the like of a measurement target.

SUMMARY

The conventional technique makes it possible to perform measurement with the amount of light suitable for the material or pattern of a measurement target even in one measurement by providing a plurality of light sources for each measurement location. In addition, using a step and scan scheme and measuring each measurement location while scanning a measurement target can perform measurement while switching light amounts for each measurement location. However, the conventional technique needs to add light sources and light-receiving elements with an increase in the number of measurement locations to be measured once. This leads to increases in the cost of an optical system and apparatus size.

The present disclosure provides a technique advantageous in measuring the height position of a measurement region.

The present disclosure in its first aspect provides a measurement method as specified in claims 1. Optional features are specified in claim 2 to 13.

The present disclosure in its second aspect provides a measurement apparatus as specified in claim 14.

The present disclosure in its third aspect provides an exposure method as specified in claim 15.

The present disclosure in its fourth aspect provides an exposure apparatus specified in claim 16.

The present disclosure in its fifth aspect provides an article manufacturing method specified in claim 17.

Further aspects of the present disclosure will become apparent from the following description of exemplary embodiments with reference to the attached drawings.

BRIEF DESCRIPTION OF THE DRAWINGS

Fig. 1 is a schematic view illustrating configurations of an exposure apparatus according to an aspect of the present disclosure.

Fig. 2 is a view for explaining configurations of a measurement unit.

Fig. 3 is a flowchart for explaining measurement processing and exposure processing in the exposure apparatus illustrated in Fig. 1.

Figs. 4A and 4B are views for explaining the adjustment of the amount of reflected light.

Figs. 5A and 5B are views for explaining the setting of measurement target locations.

Figs. 6A and 6B are views for explaining the setting of measurement target locations.

Fig. 7 is a flowchart for explaining measurement processing and exposure processing in the exposure apparatus illustrated in Fig. 1.

Fig. 8 is a flowchart for explaining measurement processing and exposure processing in the exposure apparatus illustrated in Fig. 1.

Figs. 9A and 9B are views for explaining the grouping of measurement target locations.

DESCRIPTION OF THE EMBODIMENTS

Hereinafter, embodiments will be described in detail with reference to the attached drawings. Note, the following embodiments are not intended to limit the scope of the claims. Multiple features are described in the embodiments, but it is not the case that all such features are required, and multiple such features may be combined as appropriate. Furthermore, in the attached drawings, the same reference numerals are given to the same or similar configurations, and redundant description thereof is omitted.

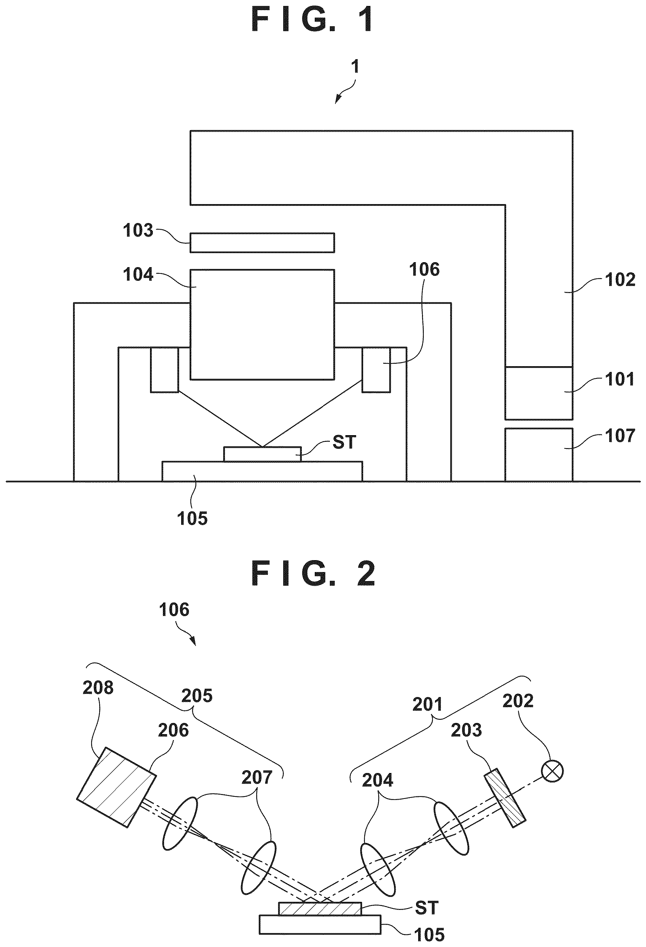

Fig. 1 is a schematic view illustrating configurations of an exposure apparatus 1 according to one aspect of the present disclosure. The exposure apparatus 1 is, for example, a lithography apparatus used in a lithography step as a manufacturing step for articles (devices) such as semiconductor elements, liquid crystal display elements, and thin-film magnetic heads to form patterns on substrates. The exposure apparatus 1 exposes a substrate to light through an original plate (reticle or mask) and transfers the pattern of the original plate to the substrate.

In the specification and the accompanying drawings, directions will be indicated on an XYZ coordinate system in which directions parallel to a plane on which a substrate is placed are defined as an X-Y plane. Directions parallel to the X-axis, the Y-axis, and the Z-axis of the XYZ coordinate system are the X direction, the Y direction, and the Z direction, respectively. A rotation about the X-axis, a rotation about the Y-axis, and a rotation about the Z-axis are $\theta X$, $\theta Y$, and $\theta Z$, respectively.

The exposure apparatus 1 includes an illumination optical system 102, an original plate stage (not shown) that can hold an original plate 103, a projection optical system 104, a substrate stage 105 that can hold a substrate ST, a measurement unit 106, and a control unit 107.

A light source 101 is implemented by, for example, an i-line mercury lamp or excimer lamp. The illumination optical system 102 illuminates the original plate 103 with light from the light source 101. A pattern to be projected onto the substrate ST is drawn on the original plate 103. The light that has passed through the original plate 103 reaches the substrate ST held by the substrate stage 105 through the projection optical system 104 to form an image of the pattern of the original plate 103. The substrate stage 105 holds the substrate ST through a substrate chuck and is configured to be movable with respect to six axes including the X-axis, the Y-axis, the Z-axis, the $\theta X$-axis, the $\theta Y$-axis, and the $\theta Z$-axis. The image of the pattern of the original plate 103 which is projected on the substrate ST is transferred onto a photosensitive material such as a resist placed (applied) on a surface of the substrate ST. The image of the pattern of the original plate 103 is transferred as a latent image onto the photosensitive material placed in each of a plurality of exposure regions of the substrate ST by repeating the operation of moving the substrate stage 105 holding the substrate ST step by step and the operation of exposing an exposure region (shot region) to light. A position measurement device (not shown) such as an interferometer or encoder accurately measures the position and posture of the substrate stage 105. The movement and positioning of the substrate stage 105 (the substrate ST) are controlled in accordance with the measurement results. This implements accurate overlay exposure.

In exposing the substrate ST to light, in order to match the height and inclination of the substrate ST with an image of the pattern of the original plate 103 (an imaging plane of the projection optical system 104), the measurement unit 106 measures the height (height position) of the substrate ST in an exposure region (in a measurement region). At least the height or inclination of the substrate stage 105 is controlled based on the measurement result obtained by the measurement unit 106. In the following description, controlling at least the height or inclination of the substrate stage 105 so as to match a reference surface (for example, the obverse surface or a surface offset from the obverse surface) of a photosensitive material in an exposure region of the substrate ST with the imaging plane of the projection optical system 104 will be referred to as focus control.

The measurement unit 106 is configured as a sensor that measures the height position of an exposure region by irradiating an exposure region (measurement region) of the substrate ST with light and detecting reflected light from the exposure region. In the present embodiment, the measurement unit 106 is embodied as an oblique incident type focus sensor that obliquely irradiates an exposure region of the substrate ST with light.

Configurations of the measurement unit 106 will be described in detail with reference to Fig. 2. The measurement unit 106 measures the height positions of a plurality of measurement target locations in an exposure region of the substrate ST. The measurement unit 106 includes an irradiation unit 201 and a detection unit 205. The irradiation unit 201 includes a light source 202 that obliquely applies light to the substrate ST held by the substrate stage 105, an irradiation pattern 203 arranged two-dimensionally, and an irradiation optical system 204 for irradiating (emitting) the substrate ST with the irradiation pattern 203. The irradiation optical system 204 may be omitted depending on the type of the light source 202 or the distance between the irradiation pattern 203 and the substrate ST. In addition, the irradiation pattern 203 and the substrate ST may be arranged to implement a Scheimpflug optical system by using the irradiation optical system 204. Employing the Scheimpflug optical system makes it possible to focus the entire region of the irradiation pattern 203 on the substrate ST and hence to improve the measurement accuracy. In addition, the Scheimpflug optical system contributes to suppressing measured value variation caused by the local inclinations of the substrate ST in measuring the height position of the substrate ST.

The detection unit 205 includes a detection optical system 207 and a camera 208. The light (reflected light) reflected by the substrate ST enters the camera 208 through the detection optical system 207. The camera 208 includes an image sensor 206 having a plurality of pixels arranged two-dimensionally. Note, however, that the detection optical system 207 may be omitted depending on the type of the light source 202 or the distance between the substrate ST and the camera 208. In addition, the substrate ST and the image sensor 206 may be arranged to implement a Scheimpflug optical system by using the detection optical system 207. Employing the Scheimpflug optical system makes it possible to focus the entire region of substrate ST on the imaging plane of the image sensor 206. In addition, the Scheimpflug optical system contributes to suppressing measured value variation caused by the local inclinations of the substrate ST in measuring the height position of the substrate ST.

The control unit 107 is implemented by an information processing apparatus (computer) including a CPU and a memory. The control unit 107 causes the exposure apparatus 1 to operate by comprehensively controlling the respective units of the exposure apparatus 1, that is, the light source 101, the illumination optical system 102, the projection optical system 104, the measurement unit 106, and the substrate stage 105 in accordance with programs stored in a storage unit. The control unit 107 controls, for example, exposure processing so as to expose the entire region of the substrate ST to light by the so-called step-and-repeat scheme of repeating exposure on each exposure region on the substrate while moving the substrate stage 105 step by step.

The control unit 107 also functions as a processing unit that performs the processing (measurement processing) of obtaining the height position of the substrate ST (its exposure region) by controlling the measurement unit 106. One of such processes is a process of obtaining the height position of the substrate ST from a change in the image (its position) of the irradiation pattern 203 obtained by the image sensor 206. As the height of the substrate ST varies, the irradiation pattern 203 with which the substrate ST is irradiated varies in the direction in which the substrate ST is irradiated with the irradiation pattern 203 from the irradiation unit 201. Since such variation in the irradiation pattern 203 appears as a change in the image of the irradiation pattern 203 obtained by the image sensor 206, the height position of the substrate ST is obtained from such change. The control unit 107 exposes the substrate ST to light while adjusting the position of the substrate ST in the height direction (Z direction) through the substrate stage 105 based on the height of the substrate ST obtained in this manner.

<First Embodiment>

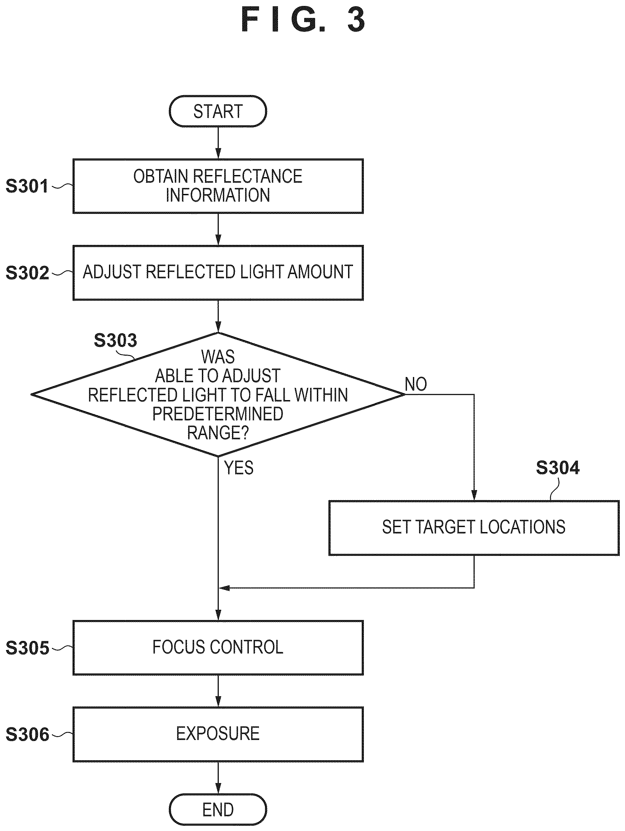

Measurement processing and exposure processing (an exposure method) according to the first embodiment will be described with reference to Fig. 3. As described above, since the present embodiment is provided with an image sensor 206 having a plurality of pixels arranged two-dimensionally, the height positions of the entire exposure region of a substrate ST to be exposed to light by the step-and-repeat scheme can be measured at once at the same timing. Note, however, that it is difficult in terms of placement and cost to implement an irradiation unit 201 (a light source 202, an irradiation pattern 203, and an irradiation optical system 204) individually for a plurality of measurement target locations in the exposure regions of the substrate ST. Accordingly, in the present embodiment, the light source 202 is implemented by a single light source, and an exposure region of the substrate ST is irradiated with light from the single light source. Note that the single light source means a light source that collectively applies light to the entire exposure region of the substrate ST but does not always mean a single light source. For example, an LED array may be used as the light source 202 or a light source that combines light beams from two light source units and emits the combined light.

In step S301, reflectance information concerning the distribution of reflectances in an exposure region (measurement region) of the substrate ST is obtained. For example, a representative sample region of the plurality of exposure regions of the substrate ST is measured by using a measurement unit 106, and a reflectance in the sample region is obtained from the output from the measurement unit 106, thereby obtaining reflectance information concerning each exposure region of the substrate ST.

In step S302, the amount of reflected light detected by the detection unit 205 is adjusted for each of a plurality of locations (default locations) set as measurement target locations in an exposure region of the substrate ST based on the reflectance information obtained in step S301. For example, the amount of light with which an exposure region of the substrate ST is irradiated, that is, the amount of light emitted from the irradiation unit 201 (the light source 202) is adjusted so as to make the amount of reflected light from each default location fall within a predetermined range (detection enable range).

A reason why step S302 is required will be described below. An exposure region of the substrate ST has various reflectances at the respective locations due to wiring, stepped locations, material differences, and the like. Accordingly, in order to accurately measure height positions in an exposure region of the substrate ST, it is necessary to adjust the amount of light with which the exposure region of the substrate ST is irradiated so as to make the amount of reflected light detected by the image sensor 206 fall within a predetermined range.

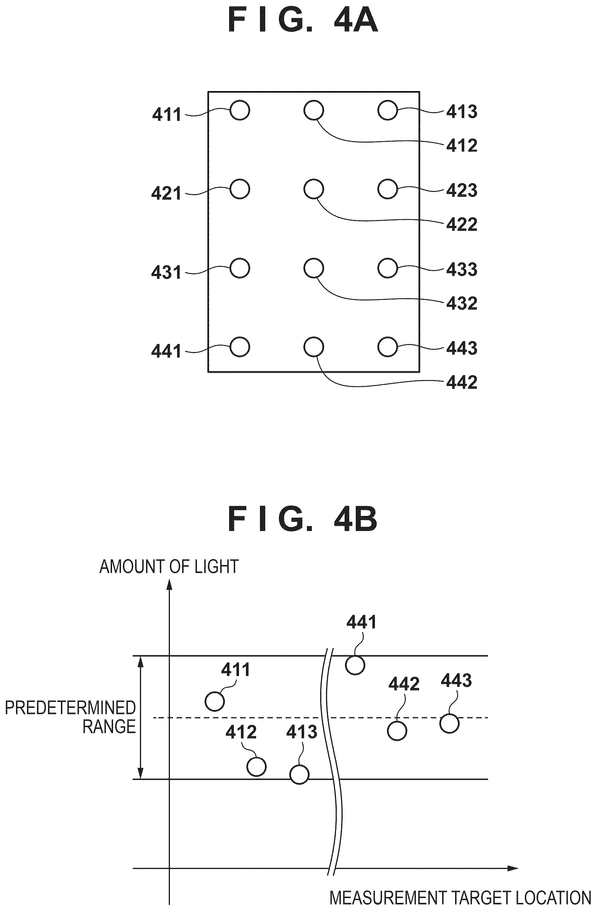

The adjustment of the amount of reflected light in step S302 will be described with reference to Figs. 4A and 4B. Referring to Fig. 4A, reference numerals 411 to 443 denote default measurement target locations (default locations) in an exposure region of the substrate ST. Fig. 4B shows the amount of reflected light from each default measurement target location detected by the image sensor 206. As described above, the amount of reflected light from each measurement target location is adjusted to fall within a predetermined range by adjusting the amount of light emitted from the irradiation unit 201.

The predetermined range is determined to meet necessary requirement for measurement accuracy from the dynamic range and S/N characteristics of the image sensor 206. If, for example, the amount of reflected light detected by the image sensor 206 is small, since the measurement accuracy decreases due to the influence of an S/N ratio, it is necessary to apply a predetermined amount or more of reflected light to the image sensor 206. On the other hand, if the amount of reflected light detected by the image sensor 206 is excessively large, the image sensor 206 is saturated to result in a deterioration in measurement accuracy.

In the present embodiment, since a single light source, that is, the one irradiation unit 201 is placed for a plurality of measurement target locations, it is necessary to adjust the amount of reflected light so as to meet the requirement for S/N ratios at all measurement target locations and inhibit the image sensor 206 from being saturated. First of all, the minimum amount of light with which an exposure region of the substrate ST is irradiated is obtained so as to make the S/N ratio of the amount of reflected light meet a predetermined threshold based on a reflectance in each measurement target location. With this minimum amount of light, it is confirmed that the image sensor 206 is not saturated at every measurement target location.

In step S303, it is determined whether the amount of reflectance light has been able to be adjusted to fall within a predetermined range with respect to every default location. If the amount of reflectance light has not been able to be adjusted to fall within the predetermined range with respect to every default location, the process shifts to step S304. In contrast to this, if the amount of reflectance light has been able to be adjusted to fall within the predetermined range with respect to every default location, the process shifts to step S305.

In step S304, measurement target locations are set (changed) in a region where the amount of reflected light detected by a detection unit 205 falls within a predetermined range in an exposure region of the substrate ST based on the reflectance information obtained in step S301. Note that in setting measurement target locations, it is also possible to set a measurement target location by presenting the user with a region where the amount of reflected light detected by the detection unit 205 falls within a predetermined range or a measurement target location as a candidate and following a user instruction (selection).

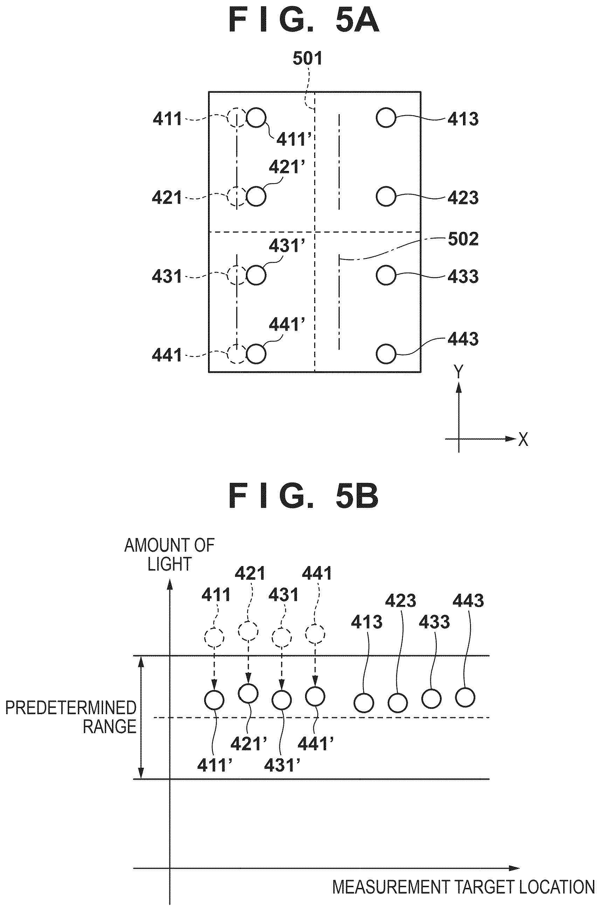

The setting of measurement target locations in step S304 will be described with reference to Figs. 5A and 5B. For example, as shown in Fig. 5A, measurement target locations 411, 421, 431, and 441 are present on a wiring pattern 502 having high reflectance. On the other hand, the reflectance decreases at a stepped location 501 such as a scribe line. In this case, the measurement target locations 411, 421, 431, and 441 present on the wiring pattern 502 are respectively shifted to measurement target locations 411', 421', 431', and 441' in a region where the amount of reflected light falls within a predetermined range. As shown in Fig. 5B, this makes it possible to make the amounts of reflected light from the measurement target locations 411', 421', 431', and 441' fall within a predetermined range so as to obtain approximately the same amounts of reflected light from the measurement target locations 413, 423, 433, and 443.

As shown in Fig. 5A, in general, the wiring pattern 502 and the stepped location 501 such as a scribe line are often present in parallel with the X or Y direction. The image sensor 206 having a plurality of pixels arranged two-dimensionally has a region of interest (ROI) function and the like and hence decreases in image read time depending on a read region or column count. Accordingly, as shown in Fig. 5A, all the measurement target locations 411 to 441 present on the same column or row (on the same straight line parallel with the first direction) are preferably shifted (changed) into a region (the measurement target locations 411' to 441') where the amount of reflected light falls within a predetermined range. In this case, all the measurement target locations 411 to 441 are preferably shifted in the parallel direction (the second direction intersecting the first direction) and further preferably shifted in the parallel direction by the same shift amounts as those of the measurement target locations 411 to 441. Note, however, that any of the measurement target locations 411 to 441 at which the amount of reflected light falls outside the predetermined range may be individually shifted within a region where the amount of reflected light falls within the predetermined range.

In step S305, focus control is performed. More specifically, the measurement unit 106 measures the height position of a measurement target location (a default measurement target location or the measurement target location set in step S304) in an exposure region of the substrate ST. At least the height or inclination of the substrate stage 105 is controlled so as to match the exposure region of the substrate ST with the imaging plane of the projection optical system 104 based on the measurement result obtained by the measurement unit 106. In other words, the position of the substrate ST in the height direction (Z direction) of the substrate ST held by the substrate stage 105 is adjusted.

In step S306, an exposure region of the substrate ST is exposed to light through the original plate 103. With this operation, an image of the pattern of the original plate 103 is transferred onto the exposure region (the photosensitive material placed thereon) of the substrate ST.

Consider here a case where the inclination amount of an exposure region of the substrate ST is obtained from measurement results (measured values) at a plurality of measurement target locations in the exposure region of the substrate ST. Assuming that measurement values at two measurement target locations are respectively represented by Data1 and Data2, and the distance between the two measurement target locations is represented by L, the inclination amount of the exposure region of the substrate ST is represented by equation (1) given below:

$$\text{inclination amount} = (\text{Data1} - \text{Data2})/L \qquad \qquad ...(1)$$

Referring to equation (1), with a decrease in the distance L as a measurement target location shifts (changes), the accuracy of the inclination amount obtained from equation (1) decreases. Accordingly, in order to prevent a decrease in inclination amount accuracy, the minimum value of the distance L required is determined as follows.

Letting the measurement reproducibilities (standard deviations) of the measured values Data1 and Data2 be A and B, respectively, a reproducibility σ of an inclination amount is defined by equation (2) given below:

$$\sigma = \text{SQRT}(A^2 + B^2)/L \qquad \qquad ...(2)$$

The distance L satisfying inequality (3) given below may be obtained from equation (2):

$$L \geq \text{SQRT}(A^2 + B^2)/\sigma m \qquad \qquad ...(3)$$

where σm is the measurement reproducibility of an inclination amount allowed for each of the measured values Data1 and Data2.

As described above, in step S304, measurement target locations are preferably set (changed) so as to make the distance L between measurement target locations become a predetermined distance or more, that is, to satisfy equation (3).

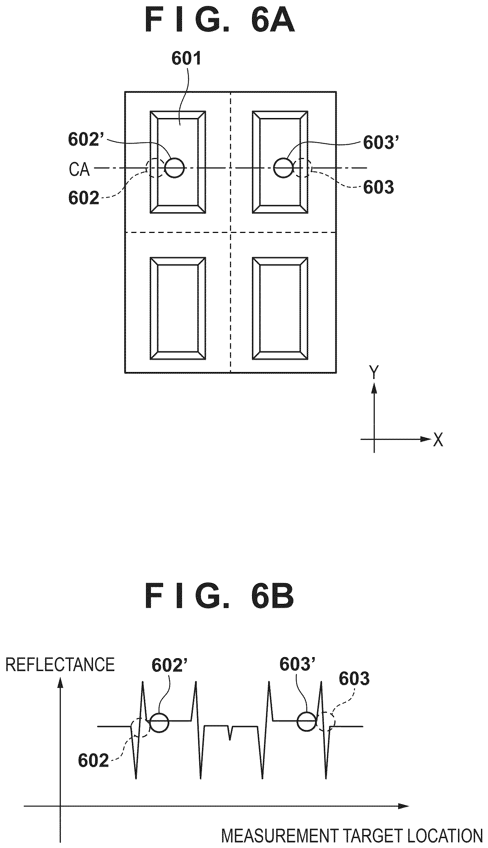

Described so far is the case where measurement target locations are set (shifted) in an exposure region of the substrate ST in consideration of the amount of reflected light detected by the detection unit 205. However, a steep change in reflectance may be a factor that affects the measurement accuracy. Accordingly, as shown in Figs. 6A and 6B, if the change rate of reflectance at a measurement target location exceeds a threshold, the measurement target location is preferably shifted (changed). In this case, the change rate of reflectance with respect to a location adjacent to each location in the exposure region of the substrate ST is obtained from the reflectance information, a measurement target location is set in a region where the change rate is equal to or less than a threshold.

For example, as shown in Fig. 6A, measurement target locations 602 and 603 are preset on a stepped location 601 such as a circuit pattern. Fig. 6B shows the distribution of reflectances on a sectional surface CA shown in Fig. 6A. Referring to Fig. 6B, although the reflectance itself is not excessively high or low at each of the measurement target locations 602 and 603, the reflectance steeply changes due to the influence of the stepped location 601. Accordingly, the measurement target locations 602 and 603 where the reflectance change rates exceed a threshold are shifted to measurement target locations 602' and 603' in a region where the reflectance change rates are equal to or less than the threshold. This makes it possible to accurately measure the height position of each measurement target location in the exposure region of the substrate ST.

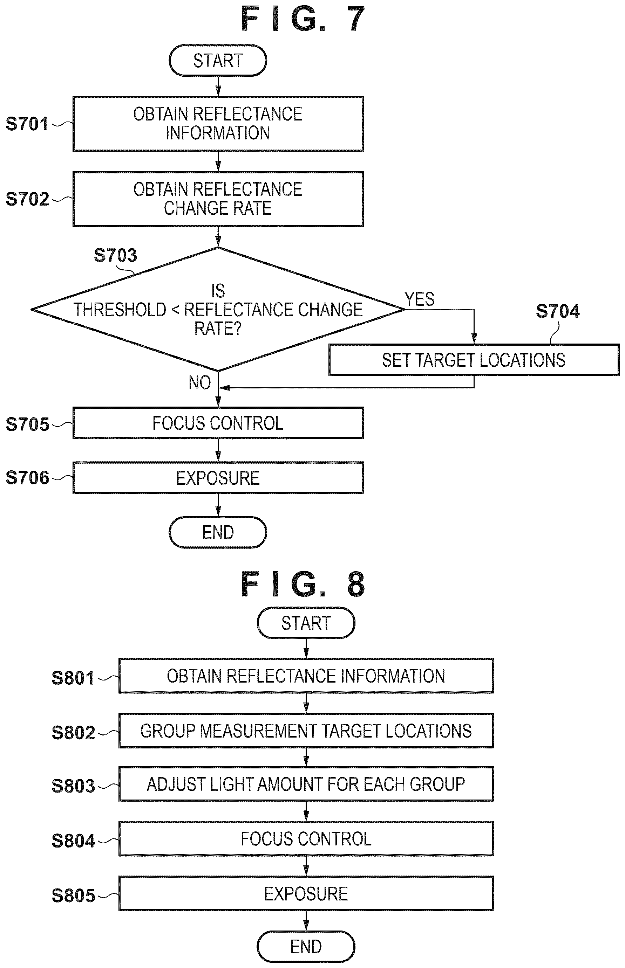

Measurement processing and exposure processing to be performed from the viewpoint of reflectance change rate at a location adjacent to each location in an exposure region of the substrate ST will be described with reference to Fig. 7. In step S701, reflectance information concerning the distribution of reflectances in the exposure region (measurement region) of the substrate ST is obtained as in step S301. In step S702, a reflectance change rate at a location adjacent to each location in the exposure region of the substrate ST is obtained from the reflectance information obtained in step S701. In step S703, it is determined, based on the reflectance ranges obtained in step S702, whether the reflectance change rate at each of a plurality of locations (default locations) set as default measurement target locations in the exposure region of the substrate ST exceeds a threshold. If the reflectance change rate at each of the plurality of default locations exceeds the threshold, the process shifts to step S704. In step S704, as described with reference to Figs. 6A and 6B, measurement target locations are set (changed) in a region where the reflectance change rates are equal to or less than the threshold in the exposure region of the substrate ST. It is also possible to present the user with a region where the reflectance change rates are equal to or less than the threshold or a measurement target location as a candidate and set a measurement target location in accordance with a user instruction (selection). In contrast to this, if the reflectance change rates at a plurality of default locations are equal to or less than the threshold, the process shifts to step S705. Since steps S705 and S706 are the same as steps S305 and S306, a detailed description of them will be omitted.

The present embodiment has exemplified the measurement processing and the exposure processing with reference to Figs. 3 and 7 from the viewpoint of the amount of reflected light detected by the detection unit 205 and the reflectance change rate with respect to a location adjacent to each location in the exposure region of the substrate ST. Note, however, that the measurement processing and the exposure processing shown in Fig. 3 and the measurement processing and the exposure processing shown in Fig. 7 can be combined with each other. For example, after measurement target locations are set from the viewpoint of the amount of reflected light, measurement target locations may be set again from the viewpoint of reflectance change rate.

<Second Embodiment>

Measurement processing and exposure processing according to the second embodiment will be described with reference to Fig. 8. Since step S805 is the same as step S306, a detailed description thereof will be omitted.

In step S801, reflectance information concerning the distribution of reflectances in an exposure region (measurement region) of a substrate ST is obtained as in step S301. In step S802, a plurality of measurement target locations set as default locations in the exposure region of the substrate ST are respectively classified into a plurality of groups (the measurement target locations are grouped) according to the reflectances based on the reflectance information obtained in step S801.

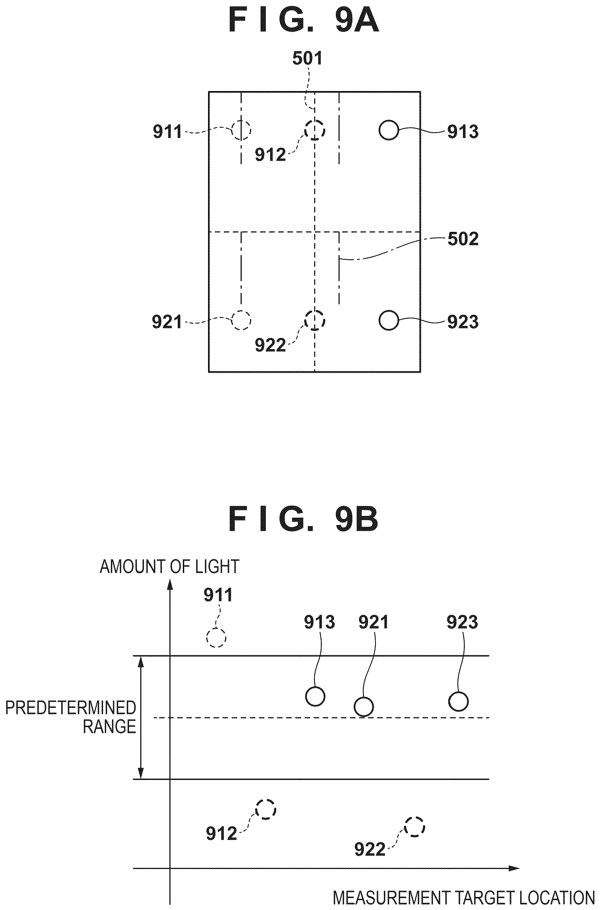

The grouping of the measurement target locations will be described in detail with reference to Figs. 9A and 9B. For example, as shown in Fig. 9A, a measurement target location 911 is present on a wiring pattern 502, and measurement target locations 912 and 922 are present on a stepped location 501. Note that measurement target locations 913, 921, and 923 are present in a region without the wiring pattern 502 and the stepped location 501. In this case, as shown in Fig. 9B, the measurement target location 911 is classified as the first group, the measurement target locations 912 and 922 are classified as the second group, and the measurement target locations 913, 921, and 923 are classified as the third group in accordance with the reflectances in an exposure region of the substrate ST.

In step S803, the amount of light with which an exposure region of the substrate ST is irradiated is adjusted to make the amount of reflected light detected by a detection unit 205 at a measurement target location belonging to each of a plurality of groups classified in step S802, that is, each group fall within a predetermined range.

In step S804, focus control is performed. More specifically, the height position of a measurement target location in the exposure region is calculated by a measurement unit 106 while the exposure region of the substrate ST is irradiated with the amount of light adjusted in step S803 for each group, that is, in the order of the first group, the second group, and the third group. At least the height or inclination of a substrate stage 105 is controlled so as to match the exposure region of the substrate ST with the imaging plane of a projection optical system 104 based on the measurement result obtained by the measurement unit 106.

The measurement processing and the exposure processing according to the present embodiment are suitable for a case where the reflectance differences in an exposure region of the substrate ST are large in subsequent steps and it is difficult to obtain a necessary amount of reflected light at once using a single light source.

A method of manufacturing an article according to the embodiment of the present disclosure is suitable for manufacturing an article such as a flat panel display, a liquid crystal display element, a semiconductor device, a MEMS or the like. This method of manufacturing includes a step of exposing a substrate coated with a photosensitive agent by using the above-described exposure apparatus 1 (exposure method) and a step of developing the exposed photosensitive agent. An etching step and an ion implantation step are performed on the substrate by using the pattern of the developed photosensitive agent as a mask, thereby forming a circuit pattern on the substrate. By repeating the steps such as these exposure, development, and etching steps, a circuit pattern formed from a plurality of layers is formed on the substrate. In a subsequent step, dicing (processing) is performed on the substrate on which the circuit pattern has been formed, and mounting, bonding, and inspection steps of a chip are performed. The method of manufacturing can further include other known steps (oxidation, deposition, vapor deposition, doping, planarization, resist removal, and the like). The method of manufacturing the article according to this embodiment is superior to the conventional method in at least one of the performance, quality, productivity, and production cost of the article.

Various embodiments have been described in detail above but it will be understood that the present disclosure is not limited to these embodiments and encompasses all modifications, variants, alternatives and equivalents falling within the scope of the appended claims.

**Claims**

1. A measurement method of measuring a height position of a measurement region by irradiating the measurement region with light and detecting reflected light from the measurement region with a sensor, the method comprising:

obtaining information concerning a distribution of reflectances in the measurement region; and
setting a measurement target location in a region where the amount of reflected light detected by the sensor falls within a predetermined range in the measurement region based on the information.

2. The method according to claim 1, wherein in the setting, the measurement target location is set by changing a location, of a plurality of locations set as default measurement target locations in the measurement region, in which the amount of reflected light detected by the sensor falls outside the predetermined range to a location in a region where the amount of reflected light detected by the sensor falls within the predetermined range.

3. The method according to claim 2, wherein the plurality of locations include a plurality of first locations present on the same straight line parallel to a first direction, and
in a case where the plurality of first locations include a location at which the amount of reflected light detected by the sensor falls outside the predetermined range, in the setting, all the plurality of first locations are changed to locations in a region where the amount of reflected light detected by the sensor falls within a predetermined range.

4. The method according to claim 3, wherein in the setting, all the plurality of first locations are shifted to locations in a region where the amount of reflected light detected by the sensor falls within a predetermined range by being shifted in a second direction intersecting the first direction.

5. The method according to claim 4, wherein in the setting, each of the plurality of first locations is shifted in the second direction by the same shift amount.

6. The method according to claim 2, wherein in the setting, the measurement target location is set so as to make a distance between the measurement target locations become not less than a predetermined distance.

7. The method according to claim 2, further comprising adjusting an amount of light with which the measurement region is irradiated so as to make the amount of reflected light detected by the sensor at each of the plurality of locations fall within the predetermined range based on the information,
wherein the setting is performed in a case where the plurality of locations include a location at which the amount of reflected light detected by the sensor falls outside the predetermined range even after the adjusting.

8. The method according to claim 1, further comprising: after the setting

obtaining a reflectance change rate at a location adjacent to each location in the measurement region from the information; and
resetting the measurement target location in a region where the change rate is not more than a threshold.

9. The method according to claim 1, wherein the sensor is an oblique incidence focus sensor configured to obliquely irradiate the measurement region with light.

10. The method according to claim 1, wherein in the obtaining, the information output from the sensor is obtained.

11. The method according to claim 1, wherein light with which the measurement region is irradiated is light from a single light source.

12. A measurement method of measuring a height position of a measurement region by irradiating the measurement region with light and detecting reflected light from the measurement region with a sensor, the method comprising:

obtaining information concerning a distribution of reflectances in the measurement region;
obtaining a reflectance change rate at a location adjacent to each location in the measurement region from the information; and
setting a measurement target location in a region where the change rate is not more than a threshold in the measurement region.

13. A measurement method of measuring a height position of a measurement region by irradiating the measurement region with light and detecting reflected light from the measurement region with a sensor, the method comprising:

obtaining information concerning a distribution of reflectances in the measurement region;

classifying each of a plurality of measurement target locations set as default locations in the measurement region to any one of a plurality of groups according to the reflectance based on the information; and

adjusting, for each of the plurality of groups, an amount of light with which the measurement region is irradiated so as to make the amount of reflected light detected by the sensor at a measurement target location belonging to the group fall within a predetermined range.

14. A measurement apparatus that measures a height position of a measurement region, the apparatus comprising:

a measurement unit configured to measure a height position of the measurement region by irradiating the measurement region with light and detecting reflected light from the measurement region with a sensor; and

a control unit configured to control the measurement unit,

wherein the control unit obtains information concerning a distribution of reflectances in the measurement region and sets a measurement target location in a region where the amount of reflected light detected by the sensor falls within a predetermined range in the measurement region based on the information.

15. An exposure method of exposing a substrate to light, the method comprising:

measuring a height position of a measurement region by irradiating a measurement region of the substrate with light and detecting reflected light from the measurement region with a sensor; and

exposing the substrate to light while adjusting a position of the substrate in a height direction based on the height position,

wherein the measuring the height position includes

obtaining information concerning a distribution of reflectances in the measurement region, and

setting a measurement target location in a region where the amount of reflected light detected by the sensor falls within a predetermined range in the measurement region based on the information.

16. An exposure apparatus that exposes a substrate to light, the apparatus comprising:

a measurement apparatus defined in claim 14 and configured to measure a height position of a measurement region of the substrate; and

a processing unit configured to expose the substrate to light while adjusting a position of the substrate in a height direction based on the height position.

17. An article manufacturing method comprising:

exposing a substrate using an exposure method defined in claim 15;

developing the substrate exposed; and

manufacturing an article from the substrate developed.

# F I G. 1

# F I G. 2

# FIG. 3

START

S301 — OBTAIN REFLECTANCE INFORMATION

S302 — ADJUST REFLECTED LIGHT AMOUNT

S303 — WAS ABLE TO ADJUST REFLECTED LIGHT TO FALL WITHIN PREDETERMINED RANGE? — NO

YES

S304 — SET TARGET LOCATIONS

S305 — FOCUS CONTROL

S306 — EXPOSURE

END

# F I G. 4A

# F I G. 4B

AMOUNT OF LIGHT

PREDETERMINED RANGE

MEASUREMENT TARGET LOCATION

# F I G. 5A

# F I G. 5B

# FIG. 6A

# FIG. 6B

REFLECTANCE

MEASUREMENT TARGET LOCATION

# FIG. 7

START

S701 — OBTAIN REFLECTANCE INFORMATION

S702 — OBTAIN REFLECTANCE CHANGE RATE

S703 — IS THRESHOLD < REFLECTANCE CHANGE RATE?

YES

S704 — SET TARGET LOCATIONS

NO

S705 — FOCUS CONTROL

S706 — EXPOSURE

END

# FIG. 8

START

S801 — OBTAIN REFLECTANCE INFORMATION

S802 — GROUP MEASUREMENT TARGET LOCATIONS

S803 — ADJUST LIGHT AMOUNT FOR EACH GROUP

S804 — FOCUS CONTROL

S805 — EXPOSURE

END

# F I G. 9A

501

911 912 913

502

921 922 923

# F I G. 9B

AMOUNT OF LIGHT

911

913  921  923

PREDETERMINED
RANGE

912

922

MEASUREMENT TARGET LOCATION

16

Europäisches
Patentamt

European
Patent Office

Office européen
des brevets

# EUROPEAN SEARCH REPORT

**Application Number**

EP 25 21 5826

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/285641 A1 (MOTOJIMA JUNICHI [JP]) 13 December 2007 (2007-12-13) | 1-7, 9-11, 14-17 | INV.<br>G01B11/06<br>G01B11/25 |
| Y | * abstract *<br>* figures 1-7 *<br>* paragraphs [0002], [0008], [0009], [0014] *<br>* paragraphs [0016] - [0022] *<br>* paragraphs [0031] - [0085] *<br>* claims 1-10 * | 7,8,12 | G03F9/00 |
| Y | US 2024/361707 A1 (MOTOJIMA JUNICHI [JP]) 31 October 2024 (2024-10-31)<br>* abstract *<br>* paragraphs [0056] - [0058] * | 8,12 | |
| X | JP H10 64980 A (CANON KK) 6 March 1998 (1998-03-06) | 1,9-11, 13 | |
| Y | * abstract *<br>* figures 1,4,5 *<br>* paragraphs [0007] - [0018], [0036] - [0039] * | 7 | |
| | | | TECHNICAL FIELDS SEARCHED (IPC) |
| X,P | WO 2025/079185 A1 (FUJI CORP [JP]) 17 April 2025 (2025-04-17)<br>* abstract *<br>* paragraphs [0028] - [0047] *<br>* figures 3,6,7 * | 1,2, 9-11,14 | G01B<br>G03F |

The present search report has been drawn up for all claims

| Place of search | Date of completion of the search | Examiner |
|---|---|---|
| Munich | 25 March 2026 | Poizat, Christophe |

EPO FORM 1503 03.82 (P04C01)

## ANNEX TO THE EUROPEAN SEARCH REPORT
## ON EUROPEAN PATENT APPLICATION NO.

EP 25 21 5826

This annex lists the patent family members relating to the patent documents cited in  the above-mentioned European search report.
The members are as contained in the European Patent Office EDP file on
The European Patent Office is in no way liable for these particulars which are merely given for the purpose of information.

25-03-2026

| Patent document cited in search report | | | Publication date | Patent family member(s) | | | Publication date |
|---|---|---|---|---|---|---|---|
| US  2007285641 | A1 | | 13-12-2007 | JP | 2008016828 | A | 24-01-2008 |
| | | | | US | 2007285641 | A1 | 13-12-2007 |
| US  2024361707 | A1 | | 31-10-2024 | CN | 118838124 | A | 25-10-2024 |
| | | | | EP | 4455793 | A2 | 30-10-2024 |
| | | | | JP | 2024157368 | A | 07-11-2024 |
| | | | | KR | 20240157548 | A | 01-11-2024 |
| | | | | TW | 202443307 | A | 01-11-2024 |
| | | | | US | 2024361707 | A1 | 31-10-2024 |
| JP  H1064980 | A | | 06-03-1998 | JP | 3376219 | B2 | 10-02-2003 |
| | | | | JP | H1064980 | A | 06-03-1998 |
| WO  2025079185 | A1 | | 17-04-2025 | NONE | | | |

EPO FORM P0459

For more details about this annex : see Official Journal of the European Patent Office, No. 12/82

**REFERENCES CITED IN THE DESCRIPTION**

**Patent documents cited in the description**

• JP 10064980 A